Europäisches Patentamt

European Patent Office

Office européen des brevets

(11) Publication number: **0 057 549**
**B1**

(12) **EUROPEAN PATENT SPECIFICATION**

(45) Date of publication of patent specification: **29.07.87**

(21) Application number: **82300367.8**

(22) Date of filing: **25.01.82**

(51) Int. Cl.⁴: **H 01 L 27/08**

(54) Semiconductor device.

(30) Priority: **29.01.81 JP 12094/81**
**08.07.81 JP 106514/81**
**08.07.81 JP 106515/81**

(43) Date of publication of application:
**11.08.82 Bulletin 82/32**

(45) Publication of the grant of the patent:
**29.07.87 Bulletin 87/31**

(84) Designated Contracting States:
**DE FR GB NL**

(56) References cited:
**EP-A-0 009 442**
**DE-A-2 800 240**
**FR-A-2 445 022**
**US-A-3 920 484**
**US-A-4 202 006**
**US-A-4 266 238**

**IBM TECHNICAL DISCLOSURE BULLETIN, vol.
22, no. 8B, January 1980 New York G. DAS et
al. "Structure for lowering power dissipation in
dielectrically isolated integrated circuits"**

(73) Proprietor: **Kabushiki Kaisha Toshiba
72, Horikawa-cho Saiwai-ku
Kawasaki-shi Kanagawa-ken 210 (JP)**

(72) Inventor: **Iwasaki, Hiroshi
1-52-6, Fujigaoka Midori-ku
Yokohama-shi (JP)**

(74) Representative: **Freed, Arthur Woolf et al
MARKS & CLERK 57-60 Lincoln's Inn Fields
London WC2A 3LS (GB)**

Courier Press, Leamington Spa, England.

## Description

This invention relates to a semiconductor device comprising both high breakdown voltage bipolar transistors and high speed semiconductor elements.

In the field of semiconductor integrated circuit, it is a matter of serious concern to develop a technique which permits producing a semiconductor body in which are formed both high breakdown voltage bipolar transistors and high speed semiconductor elements. However, to form such bipolar devices is contradictory to the formation of such semiconductor elements, rendering it difficult to develop the technique mentioned above.

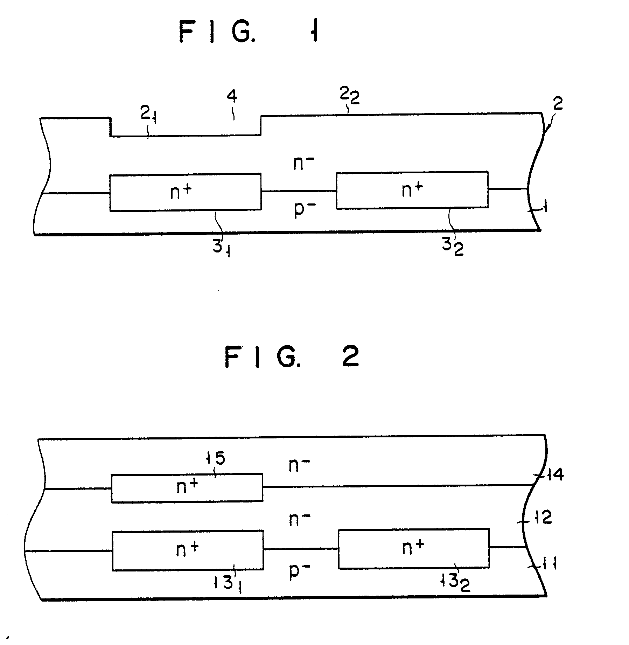

Fig. 1 shows the construction of a prior art semiconductor body used for producing a semiconductor integrated circuit. As seen from the drawing, an $n^-$-type epitaxial layer 2 is formed on a $p^-$-type semiconductor substrate 1. Also, $n^+$-type buried layers $3_1$ and $3_2$ are selectively formed at the interface between the substrate 1 and the epitaxial layer 2. Further, a recess 4 is formed by etching in the surface region of the epitaxial layer 2 facing the $n^+$-type buried layer $3_1$, with the result that the distance between the epitaxial layer surface and the buried layer is smaller in an epitaxial layer region $2_1$ above the buried layer $3_1$ than in an epitaxial layer region $2_2$ above the buried layer $3_2$. In a semiconductor body of this construction, high speed semiconductor elements is formed in the epitaxial layer region $2_1$, with high breakdown voltage semiconductor elements formed in the epitaxial layer region $2_2$, so as to form a semiconductor integrated circuit. In the prior art of Fig. 1, however, the presence of the recess 4 renders it difficult to achieve fine processings in forming desired semiconductor elements in the epitaxial layer.

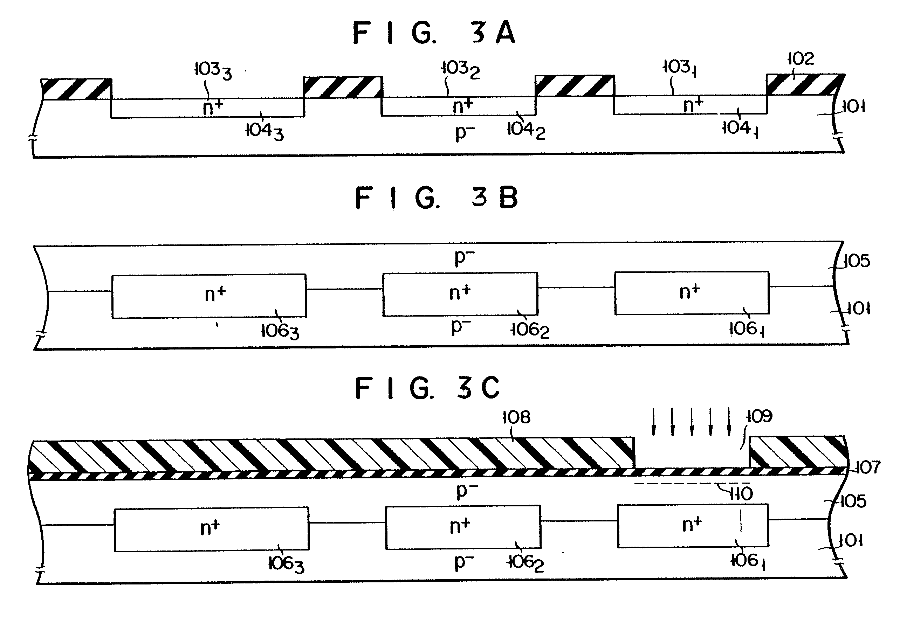

Fig. 2 shows the construction of an unpublished semiconductor body used for forming a semiconductor integrated circuit and conceived by the inventor. In the semiconductor body of Fig. 2, an $n^-$-type first epitaxial layer 12 is formed on a $p^-$-type semiconductor substrate 11. Also, $n^+$-type first buried layers $13_1$ and $13_2$ are selectively formed at the interface between the substrate 11 and the first epitaxial layer 12. The first buried layer $13_1$ may be omitted in some cases. Further, an $n^-$-type second epitaxial layer 14 is formed on the first epitaxial layer 12. As seen from the drawing, an $n^+$-type second buried layer 15 is formed at the interface between the first and second epitaxial layers 12 and 14 in a manner to face the first buried layer $13_1$. In a semiconductor body of this construction, high speed semiconductor elements are formed in the second epitaxial layer 14 above the second buried layer 15, with high breakdown voltage semiconductor elements formed above the first buried layer $13_2$ in a manner to extend through the first and second epitaxial layers 12 and 14. In the semiconductor body of Fig. 2, however, it is necessary to form by means of impurity diffusion a $p^+$-type isolation region (or a dielectric film like an oxide film acting as an isolation region) extending through the first and second epitaxial layers 12, 14 to reach the substrate 11. What should be noted is that the epitaxial layer consisting of the layers 12 and 14 is so thick that it is necessary to apply a heat treatment at a high temperature for a long time for forming the $p^+$-type isolation region mentioned above.

The heat treatment mentioned causes a severe impurity diffusion from the buried layers $13_1$, $13_2$ and 15, namely the buried layers are expanded, rendering it very difficult to control as desired the distance between the surface of the second epitaxial layer 14 and the buried layers 15 or $13_2$. It follows that the highspeed and high breakdown voltage semiconductor elements formed between the second epitaxial layer surface and the buried layer 15 and between the second epitaxial layer surface and the buried layer $13_2$, respectively fail to perform satisfactory characteristics. It may be possible to ensure a sufficient distance between the epitaxial layer surface and the buried layer by increasing the thickness of the epitaxial layer. In this case, however the $P^+$-type isolation region must be made deeper, leading to a severer heat treatment for forming the isolation region and, thus, to a greater expansion of the buried layer. In other words, the above-noted problem cannot be solved by increasing the thickness of the epitaxial layer. Incidentally, the prior art shown in Fig. 1 also gives rise to the above-noted problem inherent in the semiconductor body of Fig. 2.

US—A—4 202 006 discloses a semiconductor body having a semiconductor substrate of a first conductivity type with an epitaxial layer of a second conductivity type formed on the substrate. A first buried region of the second conductivity type is formed at an interface between the substrate and the epitaxial layer and a second buried region of the second conductivity type is formed at the interface and is spaced from the first buried region. The second region has a higher impurity concentration than the first region. A first semiconductor element is formed in the portion of the epitaxial layer which lies above the first semiconductor region and a second semiconductor element is formed in the portion of the epitaxial layer which lies above the second semiconductor region. The first semiconductor element has a relatively high voltage characteristic.

FR—A—2 445 022 discloses an integrated semiconductor device having a $p^-$-type silicon substrate on which are successively formed a $p^-$-type epitaxial layer and an $n^-$-type epitaxial layer. An $n^+$-type buried layer is formed and extends from inside the substrate, through the $p^-$-type epitaxial layer to inside the $n^-$-type epitaxial layer near to its junction with the $p^-$-type epitaxial layer. A $p^+$-type isolation region is provided and surrounds a bipolar transistor formed inside the $n^-$-type epitaxial layer. This arrangement permits the $p^+$-type isolation region to become shallower by the thickness of the $p^-$-type epitaxial layer, thus

2

shortening the diffusion time required to form the isolation region and also reduces out-diffusion of the buried layer.

An object of this invention is to provide a semiconductor device in which are formed both a high breakdown voltage bipolar transistor and a high speed semiconductor element performing satisfactory characteristics.

According to of this invention, there is provided a semiconductor device comprising:

(a) a semiconductor body including:

a p-type silicon substrate;

an epitaxial layer formed on the substrate;

a first n-type buried layer formed at part of a first interface region between the substrate and the epitaxial layer and;

a second n-type buried layer laterally spaced from the first n-type buried layer;

(b) a high speed bipolar transistor device having regions formed above the second n-type buried layer;

(c) a bipolar transistor having a high breakdown voltage and having regions formed in the epitaxial layer above the first n-type buried layer; and

(d) $P^+$-type isolation regions extending from the semiconductor device surface to the substrate and serving to electrically separate the high speed bipolar transistor device from the bipolar transistor having a high breakdown voltage.

Characterised in that the epitaxial layer is of p-type in that an n-type epitaxial layer is formed on the p-type epitaxial layer; in that the first n-type buried layer has a higher impurity concentration than the n-type epitaxial layer, in that the second n-type buried layer is formed at part of a second interface region between the p-type epitaxial layer and the n-type epitaxial layer, exclusive of that part of the second interface region which lies directly above the first n-type buried layer, in that the second n-type buried layer has a higher impurity concentration than the n-type epitaxial layer, in that the high speed bipolar transistor device is also formed in that portion of the n-type epitaxial layer which lies directly above the second n-type buried layer, in that the bipolar transistor which has a high breakdown voltage is formed also in that portion of the n-type epitaxial layer which lies above the first n-type buried layer; in that an n-type impurity region is formed in the p-type epitaxial layer, extends from the first n-type buried layer to that part of the second interface which lies above the first n-type buried layer and has an impurity concentration equal to or lower than that of the n-type epitaxial layer; and in that a third n-type buried layer is formed at the first interface, laterally spaced from the first n-type buried layer, the third n-type buried layer contacting the second n-type buried layer and having a higher impurity concentration than the n-type epitaxial layer.

It suffices to provide an isolation region of the first conductivity type in a manner to extend through the second semiconductor layer alone of the second conductivity type. Thus, the semiconductor body of the present invention permits markedly moderating the heat treating conditions, i.e., impurity diffusing conditions, for forming the isolation region, compared with the construction shown in Fig. 2. The moderate heat treatment permits suppressing the impurity diffusion from the buried layers of high impurity concentration formed at the interface between the substrate and the first semiconductor layer and between the first and second semiconductor layers, rendering it possible to form both high breakdown voltage bipolar transistors and high speed semiconductor elements performing satisfactory characteristics.

The breakdown voltage of the bipolar transistor is determined by the thickness of the first semiconductor layer. The thickness of the second semiconductor layer serves to determine the operating speed of the semiconductor elements formed together with the bipolar transistor mentioned above. The moderate heat treatment mentioned previously produces an additional effect. Specifically, the lateral diffusion of impurity is suppressed in the step of forming the isolation region. The side diffusion of the isolation region can be suppressed, rendering it possible to increase the degree of integration of the produced semiconductor device. Further, the upper surface of the semiconductor body, i.e., the surface of the second semiconductor layer, is not provided with a recess but is smooth. Thus, it is possible to apply fine pattern processings to the semiconductor body. In addition, it is possible to prevent the breakage of the interconnection mounted to the semiconductor body.

This invention can be more fully understood from the following detailed description when taken in conjunction with the accompanying drawings, in which:

Fig. 1 is a cross sectional view showing partly a prior art semiconductor body used for forming a semiconductor integrated circuit;

Fig. 2 is a cross sectional view showing partly another prior art semiconductor body used for forming a semiconductor integrated circuit;

Figs. 3A to 3I are cross sectional views collectively showing how to produce a semiconductor integrated circuit by using the semiconductor body according to an embodiment of this invention; and

Fig. 4 is a cross sectional view showing a second means for forming the $n^-$-type impurity region and the $p^+$-type impurity region in the manufacture of the integrated circuit shown in Figs. 3A to 3I.

As described above, this invention provides a semiconductor device comprising bipolar transistors of high breakdown voltage and semiconductor elements operable at high speed. The produced semiconductor device is high in integration degree and in reliability.

Example

Figs. 3A to 3I collectively show how to produce a semiconductor integrated circuit by utilizing the semiconductor body according to one embodiment of this invention. In Example, the integrated circuit comprises an npn bipolar transistor of high breakdown voltage, an npn bipolar transistor operable at high speed, and an integrated injection logic device operable at high speed.

Specifically, Fig. 3A shows that an oxide film 102 is formed by thermal oxidation on the main surface of a $p^-$-type silicon substrate 101 having a resistivity of 1 to 25 $\Omega$.cm, followed by selectively etching the oxide film 102 so as to provide openings $103_1$ to $103_3$. Then, an n-type impurity such as antimony or arsenic is selectively diffused within a hot furnace through the openings $103_1$ to $103_3$ into the substrate 101 so as to form $n^+$-type diffusion layers $104_1$ to $104_3$ having a sheet resistivity of 5 to 5 $\Omega/\square$. After formation of these diffusion layers, the remaining oxide film 102 is removed, followed by forming on the substrate surface a $p^-$-type epitaxial layer 105, i.e. first semiconductor layer) having a thickness of 3 $\mu$m or more and a resistivity of 1 $\Omega$.cm or more as shown in Fig. 3B. It should be noted that the heat in the epitaxial growth step causes the impurity contained in the diffusion layers $104_1$ to $104_3$ to be diffused into the epitaxial layer 105 so as to form $n^+$-type first buried layers $106_1$ (i.e. first semiconductor region) and $n^+$-type buried layers $106_2$ and $106_3$ (i.e., fourth semiconductor regions) around the interface between the substrate 101 and the epitaxial layer 105.

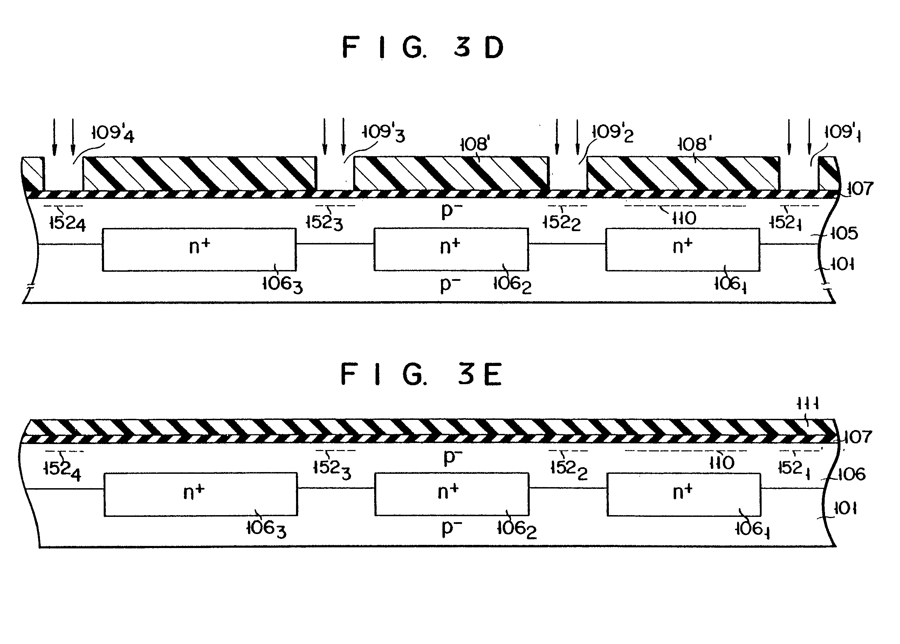

Then, a thermal oxide film 107 having a thickness of about 1,000 Å is formed on the entire surface of the epitaxial layer 105, followed by forming a photoresist film 108 on the oxide film 107 as shown in Fig. 3C. The photoresist film 108 thus formed is selectively removed by photolithography so as to provide a window 109 facing the first buried layer $106_1$, followed by introducing an n-type impurity, e.g., phosphorus, through the window 109 into the epitaxial layer 105 by ion implantation under an acceleration energy of 160 to 220 KeV and a dose of 1 to $30\times10^{11}$ cm$^{-2}$ so as to form a phosphorus ion injection layer 110. In the next step, the photoresist film 108 is removed, followed by forming again a photoresist film 108' as shown in Fig. 3D. The photoresist film 108' thus formed is selectively removed by photolithography so as to provide windows $109'_1$ to $109'_4$, followed by selectively introducing boron, i.e., p-type impurity, into the epitaxial layer 105 through the windows $109'_1$ to $109'_4$ by ion implantation under an acceleration energy of 200 KeV and a dose of 1 to $100\times10^{14}$ cm$^{-2}$ so as to form boron ion injection layers $152_1$ to $152_4$ positioned to surround the first buried layers $106_1$ and $106_3$.

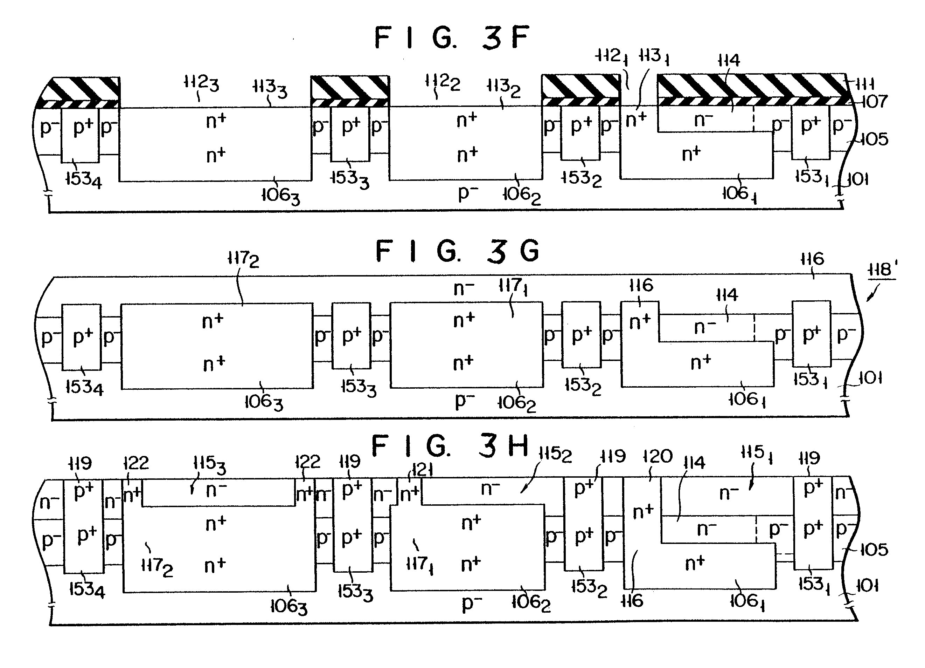

After formation of the boron ion injection layers $152_1$ to $152_4$, the photoresist film 108' is removed, followed by forming a $SiO_2$ film 111 having a thickness of about 1 $\mu$m on the thermal oxide film 107 by chemical vapor deposition (CVD), as shown in Fig. 3E. Then, the oxide films 107 and 111 is selectively removed so as to provide a diffusion window $112_1$ partially facing the $n^+$-type first buried layer $106_1$ and diffusion windows $112_2$ and $112_3$ facing the $n^+$-type first buried layers $106_2$ and $106_3$, respectively. Further, an n-type impurity, e.g., antimony or arsenic, is selectively diffused through the diffusion windows $112_1$ to $112_3$ into the epitaxial layer 105 in a hot furnace so as to form $n^+$-type diffusion layers $113_1$, $113_2$ and $113_3$ each having a sheet resistivity of 5 to 50 $\Omega/\square$. As seen from Fig. 3F, the diffusion layer $113_1$ extends to reach the buried layer $106_1$. Likewise, the diffusion layers $113_2$ and $113_3$ extend to reach the buried layers $106_2$ and $106_3$, respectively. In this thermal diffusion process, the impurity contained in the phosphorus ion injection layer 110 is diffused so as to convert the layer 110 into an $n^-$-type impurity region 114 (i.e. third semiconductor region) as shown in Fig. 3F. The impurity concentration of the region 114 is equal to or lower than that of an epitaxial layer 115 to be described later. Also, the impurity contained in the boron ion injection layers $152_1$ to $152_4$ is diffused so as to convert the layers $152_1$ to $152_4$ into $p^+$-type impurity regions $153_1$ to $153_4$.

Then, the remaining oxide films 111 and 107 are entirely removed, followed by forming on the $p^-$-type epitaxial layer 105 and $n^-$-type epitaxial layer 115 (i.e. second semiconductor layer) having a resistivity of 0.1 to 50 $\Omega$.cm and a thickness of 1 $\mu$m or more as seen from Fig. 3G. It should be noted that the heat in the epitaxial growth step causes the impurity contained in the $n^+$-type diffusion layers $113_1$ to $113_3$ to be diffused into the $n^-$-type epitaxial layer 115 so as to form an $n^+$-type diffusion layer 116 (i.e., fifth semiconductor regions). Also formed are $n^+$-type second buried layers $117_1$ and $117_2$ (i.e., second semiconductor regions) connected to the first buried layers $106_2$ and $106_3$ (i.e., fourth semiconductor regions), respectively. Further, the impurity contained in the $p^+$-type impurity regions $153_1$ to $153_4$ is diffused into the $n^-$-type epitaxial layer 115 in the epitaxial growth step as seen from Fig. 3G so as to provide a desired semiconductor body 118'.

In the next step, a p-type impurity, e.g., boron, is selectively diffused into the $n^-$-type epitaxial layer 115 of the semiconductor body 118' so as to form $p^+$-type isolation regions 119 connected to the $p^+$-type impurity regions $153_1$ to $153_4$ formed previously as seen from Fig. 3H. Naturally, the isolation regions 119 thus formed serve to electrically divide the epitaxial layer 115 into regions $115_1$, $115_2$ and $115_3$. Then, an n-type impurity, e.g., phosphorus, arsenic or mixture of phosphorus and arsenic, is selectively diffused into the divided regions $115_1$ to $115_3$ so as to form $n^+$-type deep layers 120, 121 and 122. As seen from the drawing, the layer 120 is connected to the $n^+$-type first buried layer $106_1$ via the diffusion region 116. Likewise, the layers 121 and 122 are connected to the $n^+$-type first buried layers $106_2$ and $106_3$ via the second buried layers $117_1$ and $117_2$, respectively. As seen from the drawing, the deep layer 122 is formed in a manner to surround the divided region $115_3$.

Further, a p-type impurity, e.g., boron, is selectively introduced by ion implantation into the

divided region $115_1$ followed by diffusing the implanted ions so as to form a deep p-type base region 123 having a sheet resistivity of 120 to 250 $\Omega/\square$ within the divided region $115_1$. Then, a p-type injector 124 and a p-type external base region 125 each extending to reach the $n^+$-type second buried layer $117_2$ are formed within the divided region $115_3$ by means of an ion implantation, followed by diffusion. The injector 124 and the external base region 125 are substantially equal in sheet resistivity to the base region 123. Similarly, an annular p-type external base region 126 having a sheet resistivity of 120 to 200 $\Omega/\square$ is formed within the divided region $115_2$ by means of ion plantation, followed by diffusion. The external base region 126 is shallower than the base region 123 formed in advance within the divided region $115_1$. Then, a $p^-$-type internal base region 127 having a sheet resistivity of 300 to 1,000 $\Omega/\square$ is formed in the region surrounded by the annular external base region 126 by means of ion implantation, followed by diffusion. Further, $p^{--}$-type internal base regions 128 each having a sheet resistivity of 1 to 3 $k\Omega/\square$ are formed in the regions surrounded by the external base regions 125 by means of ion implantation, followed by diffusion.

The insulation film 129 formed on the entire surface is selectively etched away so as to provide openings $130_1$ to $130_6$, followed by forming on the entire surface a polycrystalline silicon (polysilicon) film 131 doped with an n-type impurity such as phosphorus, arsenic or both phosphorus and arsenic. Then, the polysilicon film (not shown) is heated so as to allow the n-type impurity contained in the polysilicon film to be diffused through the openings $130_1$ to $130_6$ into the semiconductor region so as to form an $n^+$-type emitter region 132 within the base region 123 of the divided region $115_1$, to form an $n^+$-type enlarged region 133 in the surface region of the $n^+$-type deep layer 120 of the divided region $115_1$, to form an $n^+$-type emitter region 134 within the $p^-$-type internal base region 127 of the divided region $115_2$, to form an $n^+$-type enlarged region 135 in the surface region of the $n^+$-type deep layer 121, and to form $n^+$-type collector regions $136_1$ and $136_2$ within the $p^{--}$-type internal base regions 128 of the divided region $115_3$.

In the next step, the polysilicon film is selectively etched away so as to allow the openings $130_1$ to $130_6$ alone to be filled with the remaining polysilicon film. Then, a second insulation film 129' such as a CVD-$SiO_2$ film or a PSG film is formed on the entire surface followed by selectively removing the second insulation film 129' and the first and second insulation films 129 and 129' so as to provide contact holes $137_1$ to $137_{12}$. Finally, a metal film, e.g., Al, Al-Si or Al-Si-Cu film, is formed on the entire surface by vacuum vapor deposition, followed by patterning the metal film so as to form the interconnections mounted to the semiconductor regions, as shown in Fig. 3I. As seen from the drawing, the interconnections thus formed include an emitter electrode 138 connected via the polysilicon film 131 and the contact hole $137_1$ to the $n^+$-type emitter region 132 formed in the divided region $115_1$; a base electrode 139 connected via the contact hole $137_2$ to the p-type base region 123; a collector electrode 140 connected via the polysilicon film 131 and the contact hole $137_3$ to the $n^+$-type region 133 communicating with the first buried layer 106; an emitter electrode 141 connected via the polysilicon film 131 and the contact hole $137_5$ to the $n^+$-type emitter region 134 formed in the divided region $115_2$; a base electrode 142 connected via the contact hole $137_6$ to the p-type external base region 126; a collector electrode 143 connected via the polysilicon film 131 and the contact hole $137_7$ to the $n^+$-type region 135 communicating with the second buried layer $117_1$; an electrode 144 acting as a ground lead and connected via the contact hole $137_4$ to the $p^+$-type isolation region 119 serving to electrically isolate the divided regions $115_1$ and $115_2$; an electrode 145 acting as a ground lead and connected via the contact hole $137_8$ to the $n^+$-type deep layer 122 formed in the divided region $115_3$; electrodes $146_1$ and $146_2$ acting as output leads and connected via the polysilicon film 131 and the contact holes $137_9$ and $137_{10}$ to the $n^+$-type collector regions $136_1$ and $136_2$, respectively; an electrode 147 acting as an input lead and connected via the contact hole $137_{11}$ to the p-type external base region 125; and an injector electrode 148 connected via the contact hole $137_{12}$ to the p-type injector 124. In the semiconductor integrated circuit thus produced, an npn bipolar transistor 149 of high breakdown voltage, an npn bipolar transistor 150 operable at high speed, and an $I^2L$ (Integrated Injection Logic) circuit 151 are formed in the divided regions $115_1$, $115_2$ and $115_3$, respectively, as apparent from Fig. 3I.

To reiterate, the semiconductor body 118 used for producing the semiconductor integrated circuit comprises a $p^-$-type semiconductor substrate 101, a $p^-$-type epitaxial layer 105 (i.e., first semiconductor layer) formed on the substrate 101, an $n^-$-type epitaxial layer 115 (i.e. second semiconductor layer) formed on the layer 105, and an $n^-$-type impurity region 114 (i.e., third semiconductor region) is formed in the $p^-$-type epitaxial layer 105 and extends from the $n^+$-type first buried layer 106 (i.e., first semiconductor region) to the second interface which lies above the first buried layer 106, as seen from Figs. 3F to 3I. The impurity concentration of the region 114 is equal to or lower than that of the epitaxial layer 115. What should be noted is that the major portion of the npn bipolar transistor 149 of high breakdown voltage is located in the $n^-$-type epitaxial layer 115 and the $n^-$-type impurity region 114. This facilitates formation of the $p^+$-type isolation region 119 (i.e., seventh semiconductor region) serving to electrically separate the npn bipolar transistor 149 from the npn bipolar transistor 150 operable at high speed and the $I^2L$ circuit 151 operable at high speed. Specifically, it suffices for the isolation region 119 to extend across the $n^-$-type epitaxial layer 115 alone, rendering it possible to shorten markedly the thermal diffusion treatment for forming the isolation region 119, compared with the prior art semiconductor body shown in Fig. 2. Thus, it is possible to suppress the impurity diffusion from the buried layer $106_1$, $117_1$ and $117_2$, (i.e., first semiconductor region, second semiconductor regions) namely, the buried layers can be prevented from expansion in the step of forming the isolation region 119. It follows that it is possible to control as desired the characteristics of the bipolar transistors 149, 150 and $I^2L$ circuit 151. The shortened heat treatment mentioned above also permits suppressing the lateral impurity diffusion so as to prevent the isolation region 119 from being expanded. As a result, it is possible to produce a semiconductor integrated circuit high in integration degree.

An additional effect to be noted is that the semiconductor body *118* has a smooth surface, rendering it possible to apply fine pattern processings for forming fine semiconductor regions like base regions, emitter regions, etc. It should also be noted that the $n^+$-type diffusion layer 116 (i.e., sixth semiconductor layer) connected to the $n^+$-type first buried layer 106 is formed in the step of forming the $n^+$-type second buried layers $117_1$ and $117_2$ as seen from Fig. 3F and 3G. In other words, the diffusion layer 116 extends upward to enter the uppermost $n^-$-type epitaxial layer 115. Thus, in order to enable the $n^+$-type deep layer 120 to be connected to the diffusion layer 116, the $n^+$-type layer 120 need not be as deep as the thickness of the epitaxial layer 115. The small depth of the $n^+$-type layer 120 permits markedly shortening the thermal diffusion time for forming the layer 120 and, thus, produces effects similar to those described previously in conjunction with the isolation region 119.

In the circuit of Example shown in Fig. 3I, however, the $p^+$-type impurity regions $153_1$ to $153_4$ (i.e., fifth semiconductor regions) connected to the $p^+$-type isolation regions 119 extend across the $p^-$-type epitaxial layer 105, rendering it possible to suppress the formation of lateral parasitic transistors in question. As a result, the semiconductor integrated circuit is enabled to exhibit an improved reliability. Also, the $p^+$-type impurity regions $153_1$ to $153_4$ extend into the $n^-$-type epitaxial layer 115 as apparent from the drawing, leading to a shortened heat treatment for forming the $p^+$-type isolation regions 119. As mentioned previously, the shortened heat treatment permits controlling as desired the characteristics of the produced semiconductor integrated circuit.

It should also be noted that the $n^+$-type first buried layers $106_2$ and $106_3$ (i.e., fourth semiconductor regions) serve to decrease the sheet resistivity of the $n^+$-type second buried layers $117_1$ and $117_2$ (i.e., second semiconductor regions) connected to the layers $106_2$ and $106_3$, respectively. Thus it is possible to decrease, for example, the collector resistance of the transistor 150 formed above the $n^+$-type first buried layer $106_2$, enabling the transistor 150 to operate at a higher speed.

In the Example shown in the drawings, the $n^-$-type impurity region 114 formed within the $p^-$-type epitaxial layer 105 is smaller in width than the $n^+$-type first buried layer $106_1$, positioned below the region 114. However, it is possible to make the width of the region 114 equal to or larger than that of the buried layer $106_1$ depending on the desired transistor characteristic, etc. of the integrated circuit. Also, the $n^+$-type diffusion region 116 connected to the buried layer $106_1$ is formed within the $n^-$-type impurity region 114 in the Examples shown in the drawings. However, it is not absolutely necessary to form the diffusion region 116 within the region 114; it suffices for the diffusion region 116 to contact the $n^-$-type impurity region 114 at least partially.

In the Example shown in the drawings, the isolation region 119 is formed of a $p^+$-type diffusion layer. But, it is also possible to use a dielectric material for forming the isolation region 119. Of course, it suffices for the dielectric material layer, i.e., isolation region, to extend across the $n^-$-type epitaxial layer 115, or to contact the $p^+$-type impurity regions ($153_1$ to $153_4$), rendering it possible to shorten the heat treatment for forming the isolation region and, thus, to suppress the impurity diffusion from the $n^+$-type buried layer $117_1$, etc. Thus, the isolation region 119, even if formed of a dielectric material, permits producing the particular effects described previously in conjunction with Example. The use of a dielectric material is particularly effective for producing a semiconductor device comprising both a transistor operable at high speed and a transistor of high breakdown voltage because of reducing the parasitic capacitance.

In the Example shown in the drawings, the p-type base region 123 of the bipolar transistor 149 of high breakdown voltage is not in contact with the $n^-$-type impurity region 114. But, the base region 123 may be allowed to contact the $n^-$-type impurity region 114. Also, the base region 123 may be allowed to consist of a shallow internal base region low in impurity concentration and a deep external base region high in impurity concentration.

In the Examples shown in the drawings, the base regions of the transistors are formed separately from each other. However, it is possible to form a common base region depending on the desired transistor characteristics. For example, with a high breakdown voltage transistor having a double-base configuration, it is possible to make the external base region of the high breakdown voltage transistor common with the external base region of the $I^2L$ circuit. It is also possible to make the external base region of the high breakdown voltage transistor common with the internal base region of the high speed transistor. The use of a common base region permits simplifying the manufacturing process of the semiconductor integrated circuit.

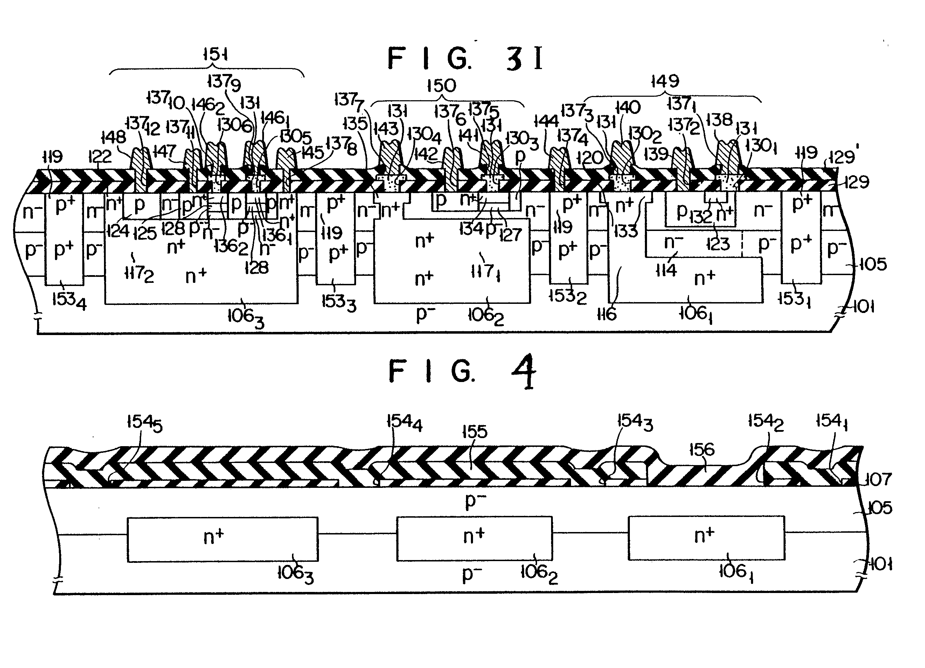

In Example, ion implantation technique is employed for forming the $n^-$-type impurity region 114 and the $p^+$-type impurity regions $153_1$ to $153_4$. Of course, the ion implantation technique may be replaced by impurity diffusion technique in Example, too, as seen from Fig. 4. Specifically, the thermal oxide film 107 having a thickness of about 3,000 Å formed on the $p^-$-type epitaxial layer 105 is selectively removed to provide the diffusion windows $154_1$, $154_3$ to $154_5$, followed by forming a boron-added glass (BSG) film 155 on the entire surface. Then, the BSG film 155 is selectively removed from the diffusion window $154_2$, followed by forming a PSG film 156 on the entire surface. Naturally, the BSG film 155 and the PSG film 156 thus formed are used as the diffusion sources for forming in the $p^-$-type epitaxial layer 105 the $n^-$-type impurity region 114 and the $p^+$-type impurity regions $153_1$ to $153_4$ in a single or more heating step.

Further, ion implantation technique is employed for forming the base regions of the transistors in the Examples shown in the drawings. But, the ion implantation technique may be replaced by thermal diffusion technique which utilizes an insulation film doped with a p-type impurity, e.g., BSG film, as the diffusion source. It should also be noted that the resistivity of the base region described previously in conjunction with Example may be changed freely depending on the desired operation characteristics of the resultant transistors.

Naturally, the conductivity type of the semiconductor regions may be reversed, i.e., the p-type and n-type regions may be changed into n-type and p-type regions, respectively, in the Examples shown in the drawings. Even if the conductivity type is reversed, the resultant semiconductor device produces effects similar to those described previously. Further, a logic circuit such as an emitter coupled logic (ECL) circuit may be formed in place of the high speed npn bipolar transistor and the $I^2L$ circuit formed in the Examples shown in the drawings. It is also possible to form unijunction transistors like MOS-FETs together with the npn bipolar transistor of high breakdown voltage.

As described above in detail, this invention provides a semiconductor integrated circuit comprising, for example, a bipolar transistor of high breakdown voltage, a bipolar transistor operable at high speed, and an $I^2L$ circuit operable at high speed. Of course, the integrated circuit mentioned is high in integration density and in reliability.

## Claims

1. A semiconductor device comprising:
(a) a semiconductor body (118') including:
a p-type silicon substrate (101);
an epitaxial layer (105) formed on the substrate (101);
a first n-type buried layer ($106_1$) formed at part of a first interface region between the substrate (101) and the epitaxial layer (105); and
a second n-type buried layer ($117_1$, $117_2$) laterally spaced from the first n-type buried layer ($106_1$);
(b) a high speed bipolar transistor device (150, 151) having regions formed above the second n-type buried layer ($117_1$, $117_2$);
(c) a bipolar transistor (149) having a high breakdown voltage and having regions formed in the epitaxial layer (105) above the first n-type buried layer ($106_1$); and
(d) $P^+$-type isolation regions (119) extending from the semiconductor device surface to the substrate and serving to electrically separate the high speed bipolar transistor device (150, 151) from the bipolar transistor (149) having a high breakdown voltage.

Characterised in that the epitaxial layer (105) is of p-type in that an n-type epitaxial layer (115) is formed on the p-type epitaxial layer (105); in that the first n-type buried layer ($106_1$) has a higher impurity concentration than the n-type epitaxial layer (115), in that the second n-type buried layer ($117_1$, $117_2$) is formed at part of a second interface region between the p-type epitaxial layer (105) and the n-type epitaxial layer (115), exclusive of that part of the second interface region which lies directly above the first n-type buried layer ($106_1$), in that the second n-type buried layer ($117_1$, $117_2$) has a higher impurity concentration than the n-type epitaxial layer (115), in that the high speed bipolar transistor device (150, 151) is also formed in that portion of the n-type epitaxial layer (115), which lies directly above the second n-type buried layer ($117_1$, $117_2$), in that the bipolar transistor (149) which has a high breakdown voltage is formed also in that portion of the n-type epitaxial layer (115) which lies above the first n-type buried layer; in that an n-type impurity region (114) is formed in the p-type epitaxial layer (105), extends from the first n-type buried layer ($106_1$) to that part of the second interface which lies above the first n-type buried layer ($106_1$) and has an impurity concentration equal to or lower than that of the n-type epitaxial layer (115); and in that a third n-type buried layer ($106_2$, $106_3$) is formed at the first interface, laterally spaced from the first n-type buried layer ($106_1$), the third n-type buried layer ($106_2$, $106_3$) contacting the second n-type buried layer ($117_1$, $117_2$) and having a higher impurity concentration than the n-type epitaxial layer (115).

2. A semiconductor device according to claim 1, characterised in that a $n^+$-type diffusion layer (116) is formed extending from part of the upper surface of the first n-type buried layer ($106_1$) to the surface of the semiconductor device, and having a higher impurity concentration than the n-type epitaxial layer (115).

3. A semiconductor device according to claim 1 or 2, characterised in that the high speed bipolar transistor device comprises an integrated injection logic circuit (151) consisting of a lateral pnp transistor comprising a carrier injection mechanism portion as an emitter region (124), and a vertical npn transistor comprising an emitter region ($115_3$) and a base region (128) which is adjacent to the collector region (125) of the pnp transistor.

4. A semiconductor device according to claim 1 or 2, characterised in that the high speed bipolar transistor device comprises a vertical npn transistor (150).

## Patentansprüche

1. Halbleitervorrichtung mit:

(a) einem Halbleiterkörper (118') mit:

einem p-dotierten Siliciumsubstrat (101);

einer auf dem Substrat (101) gebildeten Epitaxialschicht (105);

einer ersten inneren n-dotierten Schicht (106₁) die an einem Teil eines ersten Grenzflächenbereiches zwischen dem Substrat (101) und der Epitaxialschicht (105) liegt; und

eine zweite innere n-dotierte Schicht (117₁, 117₂), die seitlich im Abstand von der ersten inneren n-dotierten Schicht (106₁) liegt;

(b) einer bipolaren Hochgeschwindigkeits-Transistoranordnung (150, 151) mit Bereichen, die oberhalb der zweiten n-dotierten inneren Schicht (117₁, 117₂) liegen;

(c) einem bipolaren Transistor (149) mit einer hohen Durchschlagsspannung und mit Bereichen, die in der Epitaxialschicht (105) oberhalb der ersten n-dotierten inneren Schicht (106₁) liegen; und

(d) P⁺-dotierte Isolierungsbereiche (119), die sich von der Oberfläche der Halbleitervorrichtung zum Substrat erstrecken und dazu dienen, elektrisch die bipolare Hochgeschwindigkeits-Transistoranordnung (150, 151) von dem bipolaren Transistor (149) mit hoher Durchschlagspannung zu trennen;

dadurch gekennzeichnet, dass die Epitaxialschicht (105) p-dotiert ist, indem eine n-dotierte Epitaxialschicht (115) auf der p-dotierten Epitaxialschicht (105) gebildet wird; indem die erste n-dotierte innere Schicht (106₁) eine höhere Fremdatomkonzentration als die n-dotierte Epitaxialschicht (115) aufweist, indem die zweite n-dotierte innere Schicht (117₁, 117₂) an einem Teil eines zweiten Grenzflächenbereiches zwischen der p-dotierten Epitaxialschicht (105) und der n-dotierten Epitaxialschicht (115) gebildet wird, ausschliesslich jenes Teils des zweiten Grenzflächenbereiches, der unmittelbar über der ersten n-dotierten inneren Schicht (106₁) liegt, indem die zweite n-dotierte innere Schicht (117₁, 117₂) eine höhere Fremdatomkonzentration als die n-dotierte Epitaxialschicht (115) hat, indem die bipolare Hochgeschwindigkeits-Transistoranordnung (150, 151) ebenfalls in dem Abschnitt der n-dotierten Epitaxialschicht (115) gebildet wird, der unmittelbar über der zweiten n-dotierten inneren Schicht (117₁, 117₂) liegt, indem der bipolare Transistor (149) mit hoher Durchschlagsspannung ebenfalls in dem Abschnitt der n-dotierten Epitaxialschicht (115) ausgebildet ist, der über der ersten n-dotierten inneren Schicht liegt; indem ein n-dotierter Fremdatombereich (114) in der p-dotierten Epitaxialschicht (105) ausgebildet ist und sich von der ersten n-dotierten inneren Schicht (106₁) zu dem Abschnitt der zweiten Grenzfläche erstreckt, der über der ersten n-dotierten inneren Schicht (106₁) liegt und eine Fremdatomkonzentration aufweist, die gleich gross wie oder kleiner als jene der n-dotierten Epitaxialschicht (115) ist; und indem eine dritte n-dotierte innere Schicht (106₂, 106₃) an der ersten Grenzfläche gebildet wird, im seitlichen Abstand von der ersten n-dotierten inneren Schicht (106₁), wobei die n-dotierte innere Schicht (106₂, 106₃) an der zweiten n-dotierten inneren Schicht (117₁, 117₂) anliegt und eine höhere Fremdatomkonzentration als die n-dotierte Epitaxialschicht (115) aufweist.

2. Halbleitervorrichtung nach Anspruch 1, dadurch gekennzeichnet, dass eine n⁺-dotierte Diffusionsschicht (116) gebildet wird, die sich von einem Teil der oberen Fläche der ersten n-dotierten inneren Schicht (106₁) zur Oberfläche der Halbleitervorrichtung erstreckt und eine höhere Fremdatomkonzentration als die n-dotierte Epitaxialschicht (115) aufweist.

3. Halbleitervorrichtung nach Anspruch 1 oder 2, dadurch gekennzeichnet, dass die bipolare Hochgeschwindigkeits-Transistoranordnung eine integrierte Injektionslogikschaltung (151) umfasst, die aus einem seitlichen pnp-Transistor besteht, der einen Trägerinjektionsmechanismusabschnitt als Emitterbereich (124) aufweist, sowie einen vertikalen npn-Transistor, der einen Emitterbereich (115₃) und einen Basisbereich (128) aufweist, der neben dem Kollektorbereich (125) des pnp-Transistors liegt.

4. Halbleitervorrichtung nach Anspruch 1 oder 2, dadurch gekennzeichnet, dass die bipolare Hochgeschwindigkeits-Transistoranordnung einen vertikalen npn-Transistor (150) enthält.

## Revendications

1. Dispositif semiconducteur comprend:

a) un corps semiconducteur (118') comprenant:

un substrat de silicium de type p (101);

une couche épitaxiale (105) formée sur le substrat (101);

une première couche enterrée de type n (106₁) constituée en partie d'une première région d'interface entre le substrat (101) et la couche épitaxiale (105); et

une seconde couche enterrée de type n (117₁, 117₂) espacée latéralement de la première couche enterrée de type n (106₁);

b) un dispositif de transistor bipolaire rapide (150, 151) comprenant des régions formées au-dessus de la seconde couche enterrée de type n (117₁, 117₂);

c) un transistor bipolaire (149) ayant une tension de claquage élevée et comprenant des régions formées dans la couche épitaxiale (105) au-dessus de la première couche enterrée de type n (106₁); et

d) des régions d'isolement de type p⁺ (119) s'étendant à partir de la surface du dispositif semiconducteur vers le substrat et servant à séparer électriquement le dispositif de transistor bipolaire rapide (150, 151) par rapport au transistor bipolaire (149) ayant une tension de claquage élevée;

caractérisé en ce que la couche épitaxiale (105) est de type p, en ce qu'une couche épitaxiale de type n (115) est formée sur la couche épitaxiale de type p (105); en ce que la première couche enterrée de type n ($106_1$) a une concentration en impuretés plus élevée que la couche épitaxiale de type n (115); en ce que la seconde couche enterrée de type n ($117_1$, $117_2$) est formée en partie d'une seconde région d'interface entre la couche épitaxiale de type p (105) et la couche épitaxiale de type n (115) en dehors de la partie de la seconde région d'interface qui se trouve directement au-dessus de la première couche enterrée de type n ($106_1$); en ce que la seconde couche enterrée de type n ($117_1$, $117_2$) a une concentration en impuretés plus élevée que la couche épitaxiale de type n (115); en ce que le dispositif de transistor bipolaire rapide (150, 151) est également formé dans la partie de la couche épitaxiale de type n (115) qui se trouve directement au-dessus de la seconde couche enterrée de type n ($117_1$, $117_2$); en ce que le transistor bipolaire (149) qui a une tension de claquage élevée est formé également dans la partie de la couche épitaxiale de type n (115) qui se trouve au-dessus de la première couche enterrée de type n; en ce qu'une région d'impuretés de type n (114) est formée dans la couche épitaxiale de type p (105), s'étend à partir de la première couche enterrée de type n ($106_1$) vers la partie de la seconde interface qui se trouve au-dessus de la première couche enterrée de type n ($106_1$), et a une concentration en impuretés égale ou inférieure à celle de la couche épitaxiale de type n (115); et en ce qu'une troisième couche enterrée de type n ($106_2$, $106_3$) est formée à la première interface, latéralement espacée de la première couche enterrée de type n ($106_1$), la troisième couche enterrée de type n ($106_2$, $106_3$) étant en contact avec la seconde couche enterrée de type n ($117_1$, $117_2$) et ayant une concentration en impuretés plus élevée que la couche épitaxiale de type n (115).

2. Dispositif semiconducteur selon la revendication 1, caractérisé en ce qu'une couche de diffusion de type $n^+$ (116) est formée à partir d'une partie de la surface supérieure de la première couche enterrée de type n ($106_1$) vers la surface du dispositif semiconducteur et présente une concentration en impuretés plus élevée que la couche épitaxiale de type n (115).

3. Dispositif semiconducteur selon l'une des revendications 1 ou 2, caractérisé en ce que le dispositif de transistor bipolaire rapide comprend un circuit logique intégré à injection (151) consistant en un transistor pnp latéral comprenant une partie à mécanisme d'injection de porteurs comme région d'émetteur (124) et un transistor npn vertical comprenant une région d'émetteur ($115_3$) et une région de base (128) qui est adjacente à la région de collecteur (125) du transistor pnp.

4. Dispositif semiconducteur selon l'une des revendications 1 ou 2, caractérisé en ce que le dispositif de transistor bipolaire rapide comprend un transistor npn vertical (150).

0  057  549

# F I G.  1

$2_1$  4  $2_2$  2

$n^-$

n+    n+

$p^-$    1

$3_1$    $3_2$

# F I G.  2

15    $n^-$

n+    14

$n^-$    12

n+    n+

$p^-$    11

$13_1$    $13_2$

1

# FIG. 3A

# FIG. 3B

# FIG. 3C

# F I G. 3 D

$109'_4$    $109'_3$    $108'$    $109'_2$    $108'$    $109'_1$

$152_4$    $152_3$    $p^-$    $152_2$    $110$    $152_1$    107

$106_3$    $n^+$    $n^+$    $p^-$    $106_2$    $n^+$    $106_1$    105  101

# F I G. 3 E

111

107

$152_4$    $152_3$    $p^-$    $152_2$    $110$    $152_1$    106

$n^+$    $n^+$    $n^+$    101

$106_3$    $p^-$    $106_2$    $106_1$

0 057 549

FIG. 3F

FIG. 3G

FIG. 3H

4

FIG. 3I

FIG. 4